# EUROPEAN PATENT SPECIFICATION

(11) **EP 3 944 433 B1**
(45) Date of publication and mention of the grant of the patent: **12.06.2024**
(21) Application number: 19926091.0
(22) Date of filing: 24.04.2019
(51) Int. Cl.: H01S 5/00, H01S 5/0683, H01S 5/068, H04B 10/50, H04B 10/079, H04B 10/40, H01S 5/062, H01S 5/042, H01S 5/06

(54) **DETERIORATION DIAGNOSIS DEVICE AND DETERIORATION DIAGNOSIS METHOD OF OPTICAL TRANSCEIVER**
VORRICHTUNG UND VERFAHREN ZUR DIAGNOSE DER VERSCHLECHTERUNG EINES OPTISCHEN TRANSCEIVERS
DISPOSITIF DE DIAGNOSTIC DE DÉTÉRIORATION ET PROCÉDÉ DE DIAGNOSTIC DE DÉTÉRIORATION D'ÉMETTEUR-RÉCEPTEUR OPTIQUE

(43) Date of publication of application: 26.01.2022
(73) Proprietor: MITSUBISHI ELECTRIC CORPORATION, Chiyoda-ku Tokyo 100-8310 (JP)
(72) Inventor: SHIRAI, Satoshi, Tokyo 1008310 (JP); HIRANO, Yukio, Tokyo 1008310 (JP); NAKURA, Kenichi, Tokyo 1008310 (JP); ISHIDA, Kazuyuki, Tokyo 1008310 (JP)
(74) Representative: Pfenning, Meinig & Partner mbB
(86) International application number: PCT/JP2019/017501
(87) International publication number: WO 2020/217355

(56) References cited:
- EP-A1- 2 071 568
- WO-A1-99/14832
- JP-A- H05 259 548
- JP-A- H07 221 369
- JP-A- H08 279 642
- JP-A- S52 123 185
- JP-A- 2000 041 002
- JP-A- 2004 254 240
- JP-A- 2005 145 006
- JP-A- 2014 212 234
- JP-A- 2016 004 597
- US-A1- 2004 136 729
- US-A1- 2009 028 551
- US-A1- 2009 214 198
- US-A1- 2012 263 202
- US-A1- 2014 270 752
- US-A1- 2019 089 110

## Description

### Field

The present invention relates to a deterioration diagnosis device that diagnoses the degree of deterioration of an optical transceiver and a method for diagnosing deterioration of an optical transceiver.

### Background

Conventionally, wired optical communication using an optical fiber has been applied to various systems for its stability in communication quality. Optical communication has been used not only for conventional data transmission and reception but also in systems for performing monitoring, control, and the like. Accordingly, optical communication is required to have higher reliability than ever before. An optical transceiver to be used for optical communication is also required to have relatively high reliability, but the optical transceiver is consumable. Therefore, there is a need to monitor the degree of deterioration of an optical transceiver so that measures can be taken before the optical transceiver fails.

An optical transmitter of an optical transceiver includes a laser diode that generates an optical signal and a drive circuit that causes an electric current to flow, the current causing the laser diode to emit light. Among components constituting the optical transceiver, the laser diode is most likely to fail. Therefore, it is possible to diagnose deterioration of the optical transceiver by monitoring the degree of deterioration of the laser diode. The optical transceiver has a function of controlling a bias current for driving the laser diode so as to maintain a constant level of an optical output. When the laser diode deteriorates, the optical transceiver performs control so as to maintain a constant level of the optical output with increasing the bias current. An optical transceiver generally has a function of monitoring a bias current for driving a laser diode. There is known a technique of estimating the degree of deterioration of an optical transceiver with monitoring a bias current.

Patent Literature 1 discloses a technique of diagnosing the degree of deterioration of an optical transmitter by acquiring a bias current value of a light emitting element and an ambient temperature of the light emitting element from a monitor so as to determine the degree of deterioration of the optical transmitter, and comparing an initial bias current value corresponding to the acquired ambient temperature with the acquired bias current value with reference to a temperature table. The temperature table is stored in a memory in advance, which contains records of the initial relationship between ambient temperatures and bias current values.

### Citation List

### Patent Literature

Patent Literature 1: Japanese Patent Application Laid-open No. 2014-212234

### Summary

### Technical Problem

However, there has been a problem that the above-described conventional technique involves much testing time and testing cost. This is because in creating the temperature table, it is necessary to acquire in advance bias current values during change in temperature of the optical transmitter being worked. It is possible to reduce the testing time and the testing cost by creating a temperature table for a typical optical transmitter and applying the temperature table to other optical transmitters. In this case, however, there has been a problem that accuracy of diagnosis deteriorates depending on variation in characteristics between optical transmitters. Furthermore, in a case where an optical transmitter is purchased as a component to produce a device, it is conceivable that a temperature test itself of the optical transmitter is difficult.

The present invention has been made in view of the above circumstances, and an object of the present invention is to provide a deterioration diagnosis device capable of improving accuracy in calculating the amount of deterioration of an optical transceiver.
Exemplary solutions for deterioration diagnostics of optical transceivers similar to that as described above are also known from US 2009/028551 A1, US 2009/214198 A1, US 2012/263202 A1, US 2019/089110 A1, US 2004/136729 A1, US 2014/270752 A1, JP 2000 041002 A and JP S52 123185 A.

### Solution to Problem

In order to solve the above-mentioned problems and achieve the object, the present invention provides a deterioration diagnosis device in accordance with claim 1, and a method for deterioration diagnosis in accordance with claim

### Advantageous Effects of Invention

A deterioration diagnosis device according to the present invention has an advantageous effect that the device can improve accuracy in calculating the amount of deterioration of an optical transceiver.

### Brief Description of Drawings

FIG. 1 is a block diagram illustrating a configuration example of a communication apparatus.
FIG. 2 is a flowchart illustrating an operation of a deterioration diagnosis device.
FIG. 3 is a graph illustrating a method for calculating a correction function in a correction function calculation unit.
FIG. 4 is a graph illustrating the amount of deterioration of a bias current, calculated by a bias current change amount calculation unit.
FIG. 5 is a graph illustrating an example of temporal change in a bias current when temperature correction is not performed in the deterioration diagnosis device.
FIG. 6 is a graph illustrating an example of temporal change in a bias current when temperature correction is performed in the deterioration diagnosis device.
FIG. 7 is a diagram illustrating an example in which a processing circuit included in the deterioration diagnosis device is constituted by a processor and a memory.
FIG. 8 is a diagram illustrating an example in which the processing circuit included in the deterioration diagnosis device is constituted by dedicated hardware.

### Description of Embodiments

Hereinafter, a deterioration diagnosis device and a method for diagnosing deterioration of an optical transceiver according to an embodiment of the present invention will be described in detail with reference to the drawings. Note that the present invention is not necessarily limited by the embodiment.

### Embodiment.

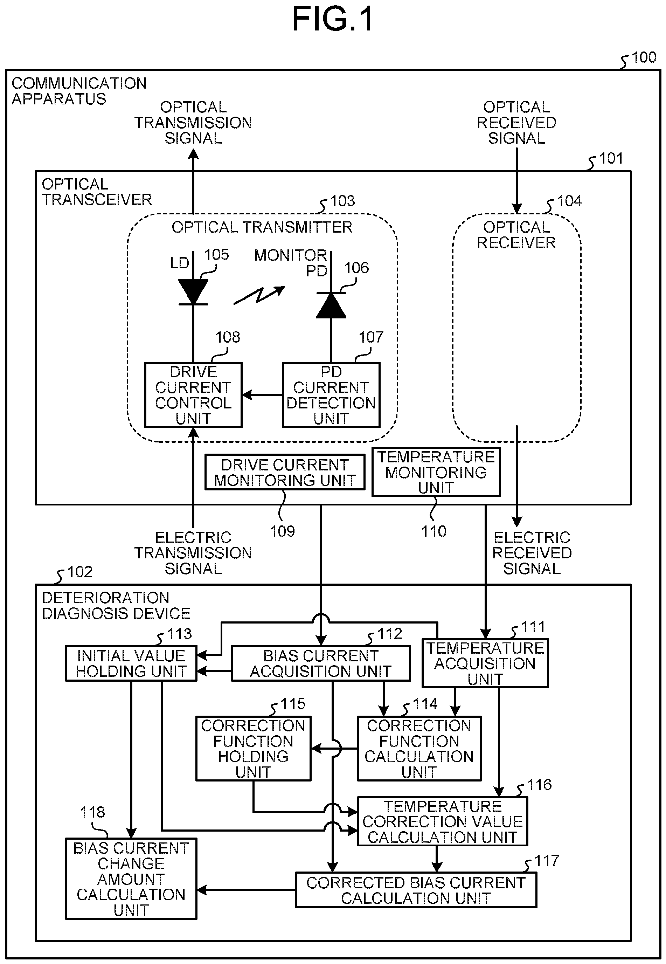

FIG. 1 is a block diagram illustrating a configuration example of a communication apparatus 100 according to an embodiment of the present invention. The communication apparatus 100 includes an optical transceiver 101 and a deterioration diagnosis device 102. The optical transceiver 101 includes an optical transmitter 103, an optical receiver 104, a drive current monitoring unit 109, and a temperature monitoring unit 110. The optical transmitter 103 converts an electric transmission signal transmitted from a post-stage device (not illustrated) into an optical transmission signal, and outputs the optical transmission signal to an optical fiber (not illustrated). The optical receiver 104 converts an optical received signal from an optical fiber (not illustrated) into an electric received signal, and outputs the electric received signal to a post-stage device (not illustrated). The optical transmitter 103 includes a laser diode 105, a monitor photo diode (PD) 106, a PD current detection unit 107, and a drive current control unit 108.

The laser diode 105 outputs an optical transmission signal under the control performed by the drive current control unit 108. The monitor PD 106 monitors the intensity of light emission of the laser diode 105. A PD current flows through the monitor PD 106 according to the intensity of light emission of the laser diode 105. The PD current detection unit 107 detects a current value of the PD current flowing through the monitor PD 106, and gives feedback to the drive current control unit 108. The drive current control unit 108 controls a drive current for driving the laser diode 105, that is, a bias current on the basis of the feedback from the PD current detection unit 107, that is, the current value of the PD current. The drive current control unit 108 controls the bias current so that the current value of the PD current is kept at a constant level, in order to maintain a constant level of a light output intensity of an optical transmission signal outputted from the optical transceiver 101.

The drive current monitoring unit 109 monitors the bias current flowing to the laser diode 105 from outside of the optical transmitter 103. The temperature monitoring unit 110 monitors the temperature of the optical transceiver 101 from outside of the optical transmitter 103. The drive current monitoring unit 109 and the temperature monitoring unit 110 can acquire desired data by, for example, communicating with a microcomputer (not illustrated in FIG. 1) that controls an operation of the optical transceiver 101, through an inter-integrated circuit (I2C) interface.

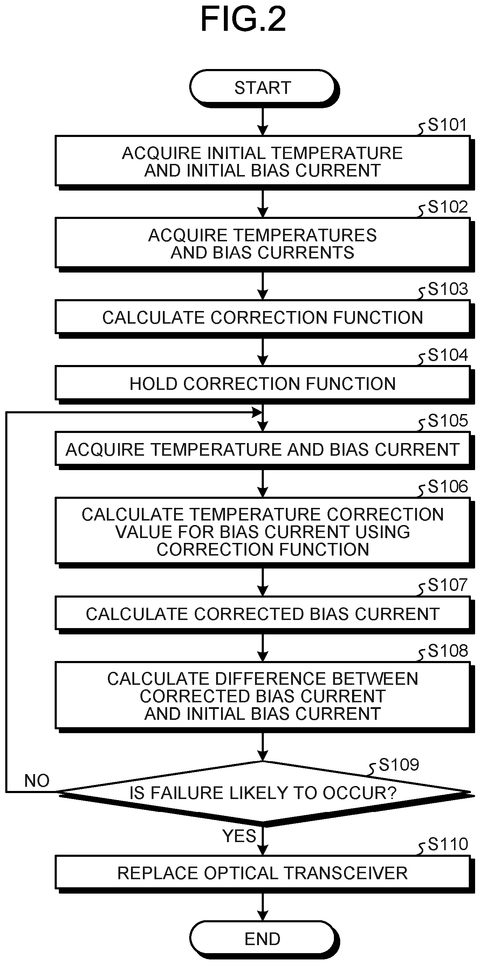

The deterioration diagnosis device 102 is incorporated in the communication apparatus 100, which serves as a part of the communication apparatus 100. The deterioration diagnosis device 102 includes a temperature acquisition unit 111, a bias current acquisition unit 112, an initial value holding unit 113, a correction function calculation unit 114, a correction function holding unit 115, a temperature correction value calculation unit 116, a corrected bias current calculation unit 117, and a bias current change amount calculation unit 118. Each constituent element included in the deterioration diagnosis device 102 will be described along with a flowchart illustrating an operation of the deterioration diagnosis device 102. FIG. 2 is a flowchart illustrating an operation of the deterioration diagnosis device 102 according to the present embodiment.

When the optical transceiver 101 initiates operation, the temperature acquisition unit 111 acquires an initial temperature T1 of the optical transceiver 101 from the temperature monitoring unit 110 of the optical transceiver 101. In addition, the bias current acquisition unit 112 acquires, from the drive current monitoring unit 109 of the optical transceiver 101, an initial bias current I1 supplied from the drive current control unit 108 to the laser diode 105 in the optical transceiver 101 (step S101). The temperature acquisition unit 111 stores the acquired initial temperature T1 in the initial value holding unit 113. The bias current acquisition unit 112 stores the acquired initial bias current I1 in the initial value holding unit 113.

The temperature acquisition unit 111 periodically acquires the temperature of the optical transceiver 101 from the temperature monitoring unit 110 of the optical transceiver 101 even after step S101. Similarly, even after step S101, the bias current acquisition unit 112 periodically acquires, from the drive current monitoring unit 109 of the optical transceiver 101, a bias current supplied from the drive current control unit 108 to the laser diode 105 in the optical transceiver 101 (step S102). In the deterioration diagnosis device 102, the temperature acquisition unit 111 acquires the temperature of the optical transceiver 101 and the bias current acquisition unit 112 acquires the bias current of the optical transceiver 101, multiple times during a single day from the start of operation of the optical transceiver 101, for example, and thereby the deterioration diagnosis device 102 can acquire data on bias currents at different temperatures.

The correction function calculation unit 114 calculates a correction function f(T) that is a function representing the relationship between the temperature and bias current of the optical transceiver 101, with use of the data on the temperatures of the optical transceiver 101 acquired by the temperature acquisition unit 111 in step S102 and the data on the bias currents flowing in the optical transceiver 101 acquired by the bias current acquisition unit 112 in step S102 (step S103). The correction function calculation unit 114 causes the correction function holding unit 115 to hold the calculated correction function f(T) (step S104).

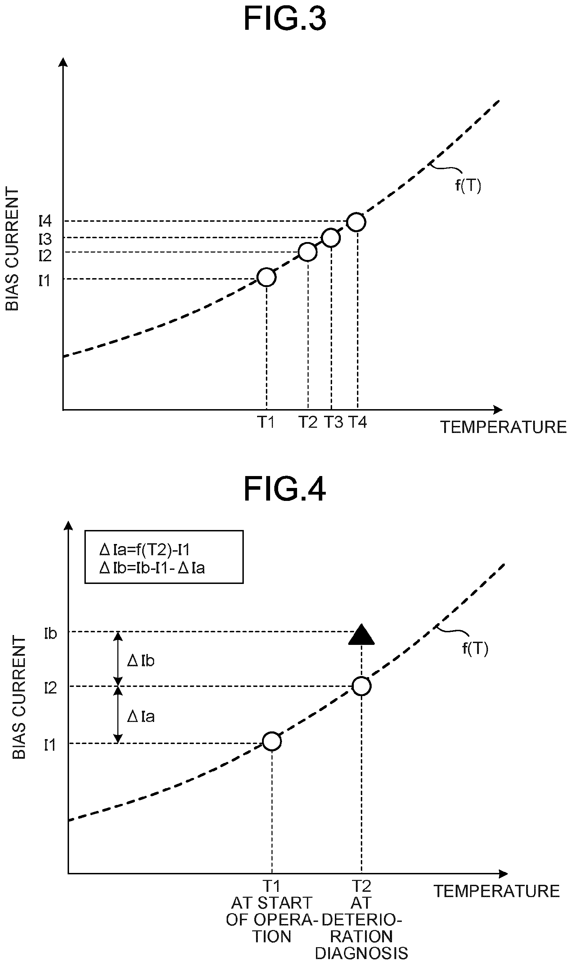

A method for calculating the correction function f(T) in the correction function calculation unit 114 will be described in detail with reference to FIG. 3. FIG. 3 is a diagram illustrating the method for calculating the correction function f(T) in the correction function calculation unit 114 according to the present embodiment. In the laser diode 105 of the optical transceiver 101, a threshold current at which light emission starts and luminous efficiency vary depending on temperature. As temperature increases, the threshold current increases and the luminous efficiency decreases in the laser diode 105. Therefore, in the optical transceiver 101, a bias current necessary for obtaining optical transmission signals with the same light output intensity increases as temperature increases, wherein the amount of increase in the bias current increases like a quadratic function, for example. Therefore, when a bias current at each temperature is plotted under the condition that a light output intensity is fixed with the horizontal axis being used to represent temperature and the vertical axis being used to represent bias current as illustrated in FIG. 3, the plotted data can be approximated by the approximate expression of a quadratic approximation curve. In FIG. 3, bias currents I1 to 14 are plotted for temperatures T1 to T4, and the approximate expression of the quadratic approximation curve based on the four plotted points results in the correction function f(T). Note that the bias current I1 for the temperature T1 may be the initial bias current I1 for the initial temperature T1.

Next, a description will be given of a method in which the deterioration diagnosis device 102 acquires bias currents at different temperatures. The temperature of the environment where the communication apparatus 100 is installed is not controlled with some exceptions, and the communication apparatus 100 is installed outdoors in some cases. In such a case, environmental temperature around the communication apparatus 100 varies during a single day, and differs between day and night. The environmental temperature also varies during a year as well as depending on climate variation. The deterioration diagnosis device 102 can generate the approximate expression of a quadratic approximation curve as illustrated in FIG. 3 under favor of such changes in environmental temperature by, for example, acquiring and plotting three or more samples of temperature and bias current during a single day. Accordingly, deterioration diagnosis device 102 uses this approximate expression of the quadratic approximation curve is used as the correction function f(T) for temperature correction of the bias current. In generating the approximate expression, accuracy of the correction function f(T) increases as the number of plotted points is larger or as a difference in temperature is larger. Nevertheless, even if the difference in temperature is small, the deterioration diagnosis device 102 can generate the same correction function f(T) as long as accurate data on at least three points of temperatures and bias currents are available.

The description returns to the flowchart of FIG. 2. On the following situation, the communication apparatus 100 is continuously operated. When deterioration diagnosis is performed in the deterioration diagnosis device 102, the temperature acquisition unit 111 acquires the temperature T2 of the optical transceiver 101, and the bias current acquisition unit 112 acquires a bias current Ib of the optical transceiver 101 (step S105). A manner of the temperature acquisition unit 111 acquiring the temperature T2 of the optical transceiver 101 and a manner of the bias current acquisition unit 112 acquiring the bias current Ib of the optical transceiver 101 are similar to those in step S102 described above, respectively.

The temperature correction value calculation unit 116 calculates a temperature correction value ΔIa for the bias current Ib acquired at the time of the deterioration diagnosis in step S105 with use of the temperature T2 acquired by the temperature acquisition unit 111 at the time of the deterioration diagnosis in step S105, the initial temperature T1 stored in the initial value holding unit 113, and the correction function f(T) held in the correction function holding unit 115 (step S106). The temperature correction value ΔIa for the bias current calculated by the temperature correction value calculation unit 116 is the amount of change in bias current caused by the temperature difference between the initial temperature T1 and the temperature T2 at the time of the deterioration diagnosis, the amount of change being caused by the temperature dependency of the bias current of the laser diode 105.

The corrected bias current calculation unit 117 corrects the bias current Ib acquired at the time of the deterioration diagnosis with use of the temperature correction value ΔIa. Specifically, the corrected bias current calculation unit 117 subtracts the temperature correction value ΔIa for the bias current based on the bias current Ib. The temperature correction value ΔIa has been calculated by the temperature correction value calculation unit 116 in step S106. The bias current Ib has been acquired by the bias current acquisition unit 112 at the time of the deterioration diagnosis in step S105. As a result, the corrected bias current calculation unit 117 can make correction with the temperature correction value ΔIa for the bias current based on the temperature difference between the temperature T2 at the time of the deterioration diagnosis and the initial temperature T1, and calculate a corrected bias current (Ib-ΔIa) obtained by conversion of the bias current Ib for the temperature T2 at the time of the deterioration diagnosis into a bias current for the initial temperature T1 (step S107).

The bias current change amount calculation unit 118 compares the initial bias current I1 that is the initial value of the bias current, with the corrected bias current (Ib-ΔIa) that has been obtained by the correction, so as to determine the state of the laser diode 105. Specifically, the bias current change amount calculation unit 118 calculates a difference between the corrected bias current (Ib-ΔIa) calculated by the corrected bias current calculation unit 117 in step S107 and the initial bias current I1 stored in the initial value holding unit 113 (step S108). A difference (Ib-I1-ΔIa) calculated by the bias current change amount calculation unit 118 is taken as a deterioration amount ΔIb of the bias current indicating the degree to which the bias current has deteriorated since the start of operation of the optical transceiver 101.

The deterioration amount ΔIb of bias current to be calculated by the bias current change amount calculation unit 118 will be described with reference to FIG. 4. FIG. 4 is a graph illustrating the deterioration amount ΔIb of bias current calculated by the bias current change amount calculation unit 118 according to the present embodiment. As described above, T1 denotes the initial temperature at the time of start of operation, I1 denotes the initial bias current, T2 denotes a temperature at the time of deterioration diagnosis, and Ib denotes a bias current. In FIG. 4, a point indicated as a black triangle points the bias current Ib at the temperature T2 at the time of the deterioration diagnosis. The temperature T2 at the time of the deterioration diagnosis is different from the initial temperature T1. Therefore, the bias current includes an increase in current due to temperature dependency, in addition to the deterioration amount ΔIb. The increase in current is a difference between the initial bias current I1 and the bias current I2 calculated by substitution of the temperature T2 at the time of the deterioration diagnosis into the correction function f(T). The increase in current is the temperature correction value ΔIa described above. Therefore, a difference between the initial bias current I1 at the time of start of operation and the corrected bias current (Ib-ΔIa) obtained by subtraction of the temperature correction value ΔIa from the bias current Ib at the time of the deterioration diagnosis is calculated as the deterioration amount ΔIb of the bias current caused by time degradation. Note that FIG. 4 illustrates a case where the initial temperature T1 < the temperature T2 at the time of the deterioration diagnosis, but when the initial temperature T1 > the temperature T2 at the time of the deterioration diagnosis, the temperature correction value ΔIa is a negative value, and so in this condition, the bias current change amount calculation unit 118 can calculate the deterioration amount ΔIb in the similar calculation manner.

The description returns to the flowchart of FIG. 2. The bias current change amount calculation unit 118 determines whether the optical transceiver 101 is likely to fail soon, based on the calculated deterioration amount ΔIb (step S109). For example, the bias current change amount calculation unit 118 compares the deterioration amount ΔIb with a threshold value prescribed for determining whether the optical transceiver 101 is likely to fail soon. When the deterioration amount ΔIb is greater than the threshold value, the bias current change amount calculation unit 118 determines that the optical transceiver 101 is likely to fail soon. When the deterioration amount ΔIb is less than the threshold value, the bias current change amount calculation unit 118 determines that the optical transceiver 101 is not likely to fail soon.

When the bias current change amount calculation unit 118 determines that the optical transceiver 101 is not likely to fail soon (step S109: No), the deterioration diagnosis device 102 continues the operation of the communication apparatus 100, and returns to step S105 to repeatedly perform deterioration diagnosis for the optical transceiver 101.

When the bias current change amount calculation unit 118 determines that the optical transceiver 101 is likely to fail soon (step S109: Yes), the deterioration diagnosis device 102 notifies a user that the optical transceiver 101 is likely to fail soon, thereby to encourage the user to replace the optical transceiver 101 (step S110). When the difference between the initial bias current I1 and the corrected bias current (Ib-ΔIa) is equal to or greater than the prescribed threshold value, the bias current change amount calculation unit 118 may instruct the user to replace the optical transceiver 101. In addition, the deterioration diagnosis device 102 may notify the user that the optical transceiver 101 is likely to fail soon by, for example, causing the bias current change amount calculation unit 118 to issue an alarm, or may provide a notification to the user by displaying information to the effect that the optical transceiver 101 is likely to fail soon, on the bias current change amount calculation unit 118 or a display unit (not illustrated). Alternatively, the deterioration diagnosis device 102 may transmit a notification to the effect that the optical transceiver 101 is likely to fail soon, to the address of a device used by the user. When the optical transceiver 101 is replaced, the deterioration diagnosis device 102 performs the operation of the flowchart illustrated in FIG. 2 from the first step, that is, step S101.

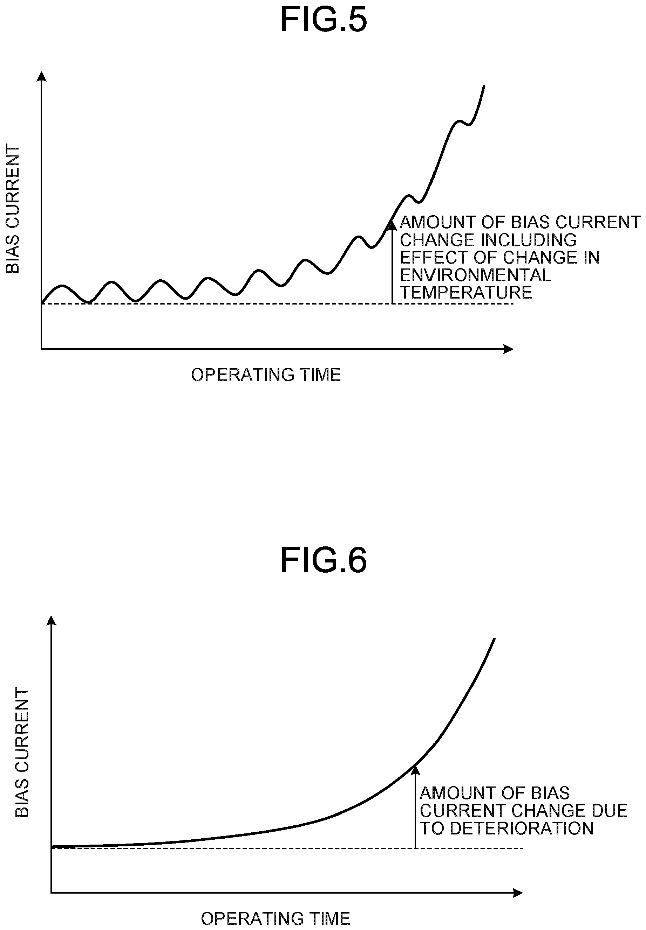

Effects to be obtained by the deterioration diagnosis device 102 of the present embodiment will be described with reference to FIGS. 5 and 6. FIG. 5 is a graph illustrating an example of temporal change in bias current when temperature correction is not performed in the deterioration diagnosis device 102 according to the present embodiment. FIG. 6 is a graph illustrating an example of temporal change in bias current when temperature correction is performed in the deterioration diagnosis device 102 according to the present embodiment. In FIGS. 5 and 6, the horizontal axis represents operating time, and the vertical axis represents bias current.

Assume that, for example, FIG. 5 illustrates a result in a case where a bias current is acquired once a day in the same time slot. Then, the bias current increases and decreases with a constant period. A period from a peak to the next peak or a period from a bottom to the next bottom illustrated in FIG. 5 just corresponds to one year period, in which temperature is supposed to vary depending on seasonal changes. In a case where deterioration diagnosis is performed in the state illustrated in FIG. 5 in the hot season, there is a possibility that bias current is diagnosed as having increased as compared with that in the start of operation, so that it may be determined that the optical transceiver has deteriorated. When temperature correction is not performed, deterioration diagnosis is performed to determine whether the optical transceiver has deteriorated, based on the amount of change in bias current including the influence of changes in environmental temperature, thereby leading to an erroneous diagnosis. On the other hand, FIG. 6 illustrates a change in bias current when temperature correction for the bias current is performed by use of the correction function f(T) of the present embodiment. The influence of changes in environmental temperature can be eliminated in the case of FIG. 6. Therefore, it is possible to calculate the real amount of deterioration in bias current, so that determination as to deterioration can be accurately performed in the deterioration diagnosis. As described above, while the amount of change in bias current including the influence of changes in environmental temperature is illustrated in the example of FIG. 5, only the amount of change in bias current due to the deterioration can be illustrated in the example of FIG. 6.

Note that in the present embodiment, the communication apparatus 100 has a configuration in which the optical transceiver 101 and the deterioration diagnosis device 102 are provided separately from each other, but this is merely an example and the present invention is not necessarily limited thereto. The communication apparatus 100 can perform deterioration diagnosis similar to that in the case of the configuration illustrated in FIG. 1 by causing a microcomputer (not illustrated) built in the optical transceiver 101 to implement the function of the deterioration diagnosis device 102. In addition, regarding generation of the correction function f(T), description has been given for a method of generating the correction function f(T) after an operation of the communication apparatus 100 is started has been described. However, in an example not in accordance with the invention, in a case where aging, that is, a pre-conditioning interim operation is performed before the start of operation, the correction function f(T) may be generated during the aging.

Next, a hardware configuration of the deterioration diagnosis device 102 will be described. In the deterioration diagnosis device 102, the temperature acquisition unit 111 and the bias current acquisition unit 112 serve as input interfaces acquiring data from the optical transceiver 101. The initial value holding unit 113 and the correction function holding unit 115 correspond to a memory or memories. The correction function calculation unit 114, the temperature correction value calculation unit 116, the corrected bias current calculation unit 117, and the bias current change amount calculation unit 118 are implemented by a processing circuit. The processing circuit may be a memory and a processor that executes programs stored in the memory, or may be a dedicated hardware set.

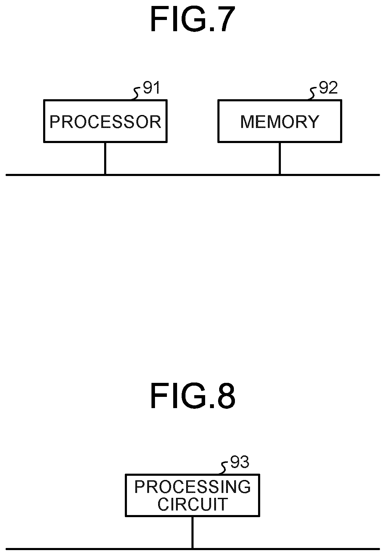

FIG. 7 is a diagram illustrating an example in which the processing circuit included in the deterioration diagnosis device 102 according to the present embodiment is configured using a processor and a memory. In a case where the processing circuit is configured using a processor 91 and a memory 92, each function of the processing circuit of the deterioration diagnosis device 102 is implemented by software, firmware, or a combination of software and firmware. The software or firmware is described as a program, and stored in the memory 92. In the processing circuit, the processor 91 reads and executes the program stored in the memory 92 to thereby implement each function of the processing circuit. That is, the processing circuit has the memory 92 for storing programs by which processing of the deterioration diagnosis device 102 is performed as a result. In addition, it can also be said that these programs cause a computer to execute or carry out the procedure and method of the deterioration diagnosis device 102.

Here, the processor 91 may be a central processing unit (CPU), a processing device, an arithmetic device, a microprocessor, a microcomputer, a digital signal processor (DSP), or the like. Furthermore, for example, the memory 92 corresponds to a nonvolatile or volatile semiconductor memory such as a random access memory (RAM), a read only memory (ROM), a flash memory, an erasable programmable ROM (EPROM), or an electrically EPROM (EEPROM) (registered trademark); a magnetic disk; a flexible disk; an optical disk; a compact disk; a mini disk; a digital versatile disc (DVD); or the like.

FIG. 8 is a diagram illustrating an example in which the processing circuit included in deterioration diagnosis device 102 according to the present embodiment is configured using dedicated hardware. In a case where the processing circuit is configured using dedicated hardware, the processing circuit 93 illustrated in FIG. 8 corresponds to, for example, a single circuit, a composite circuit, a programmed processor, a parallel-programmed processor, an application specific integrated circuit (ASIC), a field programmable gate array (FPGA), or any combination thereof. The functions of the deterioration diagnosis device 102 may be separately implemented by the processing circuit 93 on function-by-function basis, or may be implemented by the processing circuitry 93 in a bundle of functions.

Note that some of the functions of the deterioration diagnosis device 102 may be implemented by dedicated hardware, and some other of the functions thereof may be implemented by software or firmware. Thus, the processing circuit can implement each of the above-described functions by means of dedicated hardware, software, firmware, or a combination thereof.

As described above, according to the present embodiment, the deterioration diagnosis device 102 acquires the bias current and temperature of the laser diode 105 at regular intervals after the start of operation of the communication apparatus 100 equipped with the optical transceiver 101, and generates a correction function based on the relationship between the acquired temperatures and the bias currents at different temperatures. The deterioration diagnosis device 102 calculates a temperature correction value with use of a temperature acquired at the time of deterioration diagnosis and the correction function. In addition, the deterioration diagnosis device 102 calculates a corrected bias current obtained by conversion of a bias current for the temperature at the time of the deterioration diagnosis into a bias current for the initial temperature. Then, the deterioration diagnosis device 102 calculates a difference between the corrected bias current and the initial bias current. As a result, the deterioration diagnosis device 102 calculates a deterioration amount for which correction has been made in terms of the temperature dependency of the laser diode 105. Consequently, the deterioration diagnosis device 102 can improve accuracy in calculation of the amount of deterioration of the optical transceiver 101. In addition, the deterioration diagnosis device 102 does not need to generate a temperature table or the like in advance, or rather, the deterioration diagnosis device 102 can reduce a testing time and a testing cost.

The configurations set forth in the above embodiment show examples of the content of the present invention, and can be combined with other publicly known techniques and partially omitted and/or modified without departing from the scope of the present invention which is defined by the claims.

### Reference Signs List

100 communication apparatus; 101 optical transceiver; 102 deterioration diagnosis device; 103 optical transmitter; 104 optical receiver; 105 laser diode; 106 monitor PD; 107 PD current detection unit; 108 drive current control unit; 109 drive current monitoring unit; 110 temperature monitoring unit; 111 temperature acquisition unit; 112 bias current acquisition unit; 113 initial value holding unit; 114 correction function calculation unit; 115 correction function holding unit; 116 temperature correction value calculation unit; 117 corrected bias current calculation unit; 118 bias current change amount calculation unit.

## Claims

1. A deterioration diagnosis device (102) for diagnosing deterioration of an optical transceiver (101), the deterioration diagnosis device (102) comprising:
a temperature acquisition unit (111) configured to acquire a temperature of the optical transceiver (101) including a laser diode (105), the laser diode (105) being configured for outputting an optical transmission signal;
a bias current acquisition unit (112) configured to acquire a bias current flowing through the laser diode (105);
a drive current control unit (108) configured to control the bias current flowing through the laser diode in order to make a light output intensity of the optical transmission signal constant;
a correction function calculation unit (114) configured to calculate a correction function representing a plurality of temperatures and a plurality of bias currents, the plurality of temperatures being obtained as a result of the temperature acquisition unit (111) acquiring temperature of the optical transceiver (101) multiple times during a specific period of time after operation is started, the plurality of bias currents being obtained as a result of the bias current acquisition unit (112) acquiring bias current of the laser diode (105) multiple times during the specific period of time after the operation is started;
a temperature correction value calculation unit (116) configured to calculate a temperature correction value for a bias current acquired by the bias current acquisition unit (112) at the time of deterioration diagnosis after the specific period of time, with use of a temperature of the optical transceiver (101) acquired by the temperature acquisition unit (111) at the time of deterioration diagnosis after the specific period of time, an initial temperature, and the correction function, the temperature correction value representing an amount of change caused by a temperature difference between the initial temperature and the temperature acquired at the time of the deterioration diagnosis, the initial temperature being a temperature of the optical transceiver (101) acquired by the temperature acquisition unit (111) when the operation is started before the specific period of time;
a corrected bias current calculation unit (117) configured to correct the bias current using the temperature correction value, the bias current being acquired at the time of the deterioration diagnosis; and
a bias current change amount calculation unit (118) configured to compare a difference between an initial bias current and a corrected bias current with a prescribed threshold value, the initial bias current being an initial value of a bias current acquired by the bias current acquisition unit (112) when the operation is started before the specific period of time, the corrected bias current being obtained by correcting the bias current, the bias current change amount calculation unit (118) determining that the laser diode (105) included in the optical transceiver (101) has deteriorated and issuing an instruction to replace the optical transceiver (101) when the difference is equal to or greater than the prescribed threshold value.

2. A method for diagnosing deterioration of an optical transceiver (101) using a deterioration diagnosis device (102) for diagnosing deterioration of an optical transceiver (101), the method comprising:
a first step of causing a temperature acquisition unit (111) to acquire a temperature of the optical transceiver (101) including a laser diode (105), the laser diode (105) outputting an optical transmission signal;
a second step of causing a bias current acquisition unit (112) to acquire a bias current flowing through the laser diode (105), wherein a drive current control unit (108) controls the bias current flowing through the laser diode in order to make a light output intensity of the optical transmission signal constant;
a third step of causing a correction function calculation unit (114) to calculate a correction function representing relationships between a plurality of temperatures and a plurality of bias currents, the plurality of temperatures being obtained as a result of the temperature acquisition unit (111) acquiring temperature of the optical transceiver (101) multiple times during a specific period of time after operation is started, the plurality of bias currents being obtained as a result of the bias current acquisition unit (112) acquiring bias current of the laser diode (105) multiple times during the specific period of time after the operation is started;
a fourth step of causing a temperature correction value calculation unit (116) to calculate a temperature correction value for a bias current acquired by the bias current acquisition unit (112) at the time of deterioration diagnosis after the specific period of time, with use of a temperature of the optical transceiver (101) acquired by the temperature acquisition unit (111) at the time of deterioration diagnosis after the specific period of time, an initial temperature, and the correction function, the temperature correction value representing an amount of change caused by a temperature difference between the initial temperature and the temperature acquired at the time of the deterioration diagnosis, the initial temperature being a temperature of the optical transceiver (101) acquired by the temperature acquisition unit (111) when the operation is started before the specific period of time;
a fifth step of causing a corrected bias current calculation unit (117) to correct the bias current using the temperature correction value, the bias current being acquired at the time of the deterioration diagnosis; and
a sixth step of causing a bias current change amount calculation unit (118) to compare a difference between an initial bias current and a corrected bias current with a prescribed threshold value, the initial bias current being an initial value of a bias current acquired by the bias current acquisition unit (112) when the operation is started before the specific period of time, the corrected bias current being obtained by correcting the bias current, and causing the bias current change amount calculation unit (118) to determine that the laser diode (105) included in the optical transceiver (101) has deteriorated and issue an instruction to replace the optical transceiver (101) when the difference is equal to or greater than the prescribed threshold value.

## Patentansprüche

1. Verschlechterungsdiagnosevorrichtung (102) zum Diagnostizieren der Verschlechterung eines optischen Transceivers (101), wobei die Verschlechterungsdiagnosevorrichtung (102) umfasst:
eine Temperaturerfassungseinheit (111), die eingerichtet ist, eine Temperatur des optischen Transceivers (101) zu erfassen, enthaltend eine Laserdiode (105), wobei die Laserdiode (105) eingerichtet ist, ein optisches Übertragungssignal auszugeben;
eine Vorstromerfassungseinheit (112), die eingerichtet ist, einen Vorstrom zu erfassen, der durch die Laserdiode (105) fließt;
eine Antriebsstrom-Steuereinheit (108), die eingerichtet ist, den durch die Laserdiode fließenden Vorstrom zu steuern, um eine Lichtausgangsintensität des optischen Übertragungssignals konstant zu halten;
eine Korrekturfunktionsberechnungseinheit (114), die eingerichtet ist, eine Korrekturfunktion zu berechnen, die eine Vielzahl von Temperaturen und eine Vielzahl von Vorströmen repräsentiert, wobei die Vielzahl von Temperaturen als ein Ergebnis der Temperaturerfassungseinheit (111) erhalten wird, die die Temperatur des optischen Transceivers (101) mehrere Male während einer spezifischen Zeitspanne nach dem Start des Betriebs erfasst, wobei die Vielzahl von Vorströmen als ein Ergebnis der Vorstromerfassungseinheit (112) erhalten wird, die den Vorstrom der Laserdiode (105) mehrere Male während der spezifischen Zeitspanne nach dem Start des Betriebs erfasst;
eine Temperaturkorrekturwert-Berechnungseinheit (116), die eingerichtet ist, einen Temperaturkorrekturwert für einen Vorstrom zu berechnen, der von der Vorstromerfassungseinheit (112) zum Zeitpunkt der Verschlechterungsdiagnose nach der spezifischen Zeitspanne erfasst wird, unter Verwendung einer Temperatur des optischen Transceivers (101), die von der Temperaturerfassungseinheit (111) zum Zeitpunkt der Verschlechterungsdiagnose nach der spezifischen Zeitspanne erfasst wird, eine Anfangstemperatur und die Korrekturfunktion, wobei der Temperaturkorrekturwert einen Änderungsbetrag darstellt, der durch eine Temperaturdifferenz zwischen der Anfangstemperatur und der zum Zeitpunkt der Verschlechterungsdiagnose erfassten Temperatur verursacht wird, wobei die Anfangstemperatur eine Temperatur des optischen Transceivers (101) ist, die von der Temperaturerfassungseinheit (111) erfasst wird, wenn der Betrieb vor der spezifischen Zeitspanne gestartet wird;
eine Einheit (117) zur Berechnung des korrigierten Vorstroms, die eingerichtet ist, den Vorstrom unter Verwendung des Temperaturkorrekturwertes zu korrigieren, wobei der Vorstrom zum Zeitpunkt der Verschlechterungsdiagnose erfasst wird; und
eine Vorstrom-Änderungsbetrags-Berechnungseinheit (118), die eingerichtet ist, eine Differenz zwischen einem anfänglichen Vorstrom und einem korrigierten Vorstrom mit einem vorgeschriebenen Schwellenwert zu vergleichen, wobei der anfängliche Vorstrom ein Anfangswert eines Vorstroms ist, der von der Vorstromerfassungseinheit (112) erfasst wird, wenn der Betrieb vor der spezifischen Zeitspanne gestartet wird, wobei der korrigierte Vorstrom durch Korrigieren des Vorstroms erhalten wird, wobei die Vorstrom-Änderungsbetrags-Berechnungseinheit (118) bestimmt, dass sich die in dem optischen Transceiver (101) enthaltene Laserdiode (105) verschlechtert hat, und eine Anweisung zum Austausch des optischen Transceivers (101) ausgibt, wenn die Differenz gleich oder größer als der vorgeschriebene Schwellenwert ist.

2. Verfahren zur Diagnose der Verschlechterung eines optischen Transceivers (101) unter Verwendung einer Verschlechterungsdiagnosevorrichtung (102) zur Diagnose der Verschlechterung eines optischen Transceivers (101), wobei das Verfahren umfasst:
einen ersten Schritt des Veranlassens einer Temperaturerfassungseinheit (111), eine Temperatur des optischen Transceivers (101) zu erfassen, enthaltend eine Laserdiode (105), wobei die Laserdiode (105) ein optisches Übertragungssignal ausgibt;
einen zweiten Schritt des Veranlassens einer Vorstromerfassungseinheit (112), einen durch die Laserdiode (105) fließenden Vorstrom zu erfassen, wobei eine Antriebsstrom-Steuereinheit (108) den durch die Laserdiode fließenden Vorstrom steuert, um eine Lichtausgangsintensität des optischen Übertragungssignals konstant zu machen;
einen dritten Schritt des Veranlassens einer Korrekturfunktionsberechnungseinheit (114), eine Korrekturfunktion zu berechnen, die Beziehungen zwischen einer Vielzahl von Temperaturen und eine Vielzahl von Vorströmen repräsentiert, wobei die Vielzahl von Temperaturen als ein Ergebnis der Temperaturerfassungseinheit (111) erhalten wird, die die Temperatur des optischen Transceivers (101) mehrere Male während einer spezifischen Zeitspanne nach dem Start des Betriebs erfasst, wobei die Vielzahl von Vorströmen als ein Ergebnis der Vorstromerfassungseinheit (112) erhalten wird, die den Vorstrom der Laserdiode (105) mehrere Male während der spezifischen Zeitspanne nach dem Start des Betriebs erfasst;
einen vierten Schritt des Veranlassens einer Temperaturkorrekturwert-Berechnungseinheit (116), einen Temperaturkorrekturwert für einen Vorstrom zu berechnen, der von der Vorstromerfassungseinheit (112) zum Zeitpunkt der Verschlechterungsdiagnose nach der spezifischen Zeitspanne erfasst wird, unter Verwendung einer Temperatur des optischen Transceivers (101), die von der Temperaturerfassungseinheit (111) zum Zeitpunkt der Verschlechterungsdiagnose nach der spezifischen Zeitspanne erfasst wird, eine Anfangstemperatur und die Korrekturfunktion, wobei der Temperaturkorrekturwert einen Änderungsbetrag darstellt, der durch eine Temperaturdifferenz zwischen der Anfangstemperatur und der zum Zeitpunkt der Verschlechterungsdiagnose erfassten Temperatur verursacht wird, wobei die Anfangstemperatur eine Temperatur des optischen Transceivers (101) ist, die von der Temperaturerfassungseinheit (111) erfasst wird, wenn der Betrieb vor der spezifischen Zeitspanne gestartet wird;
einen fünften Schritt des Veranlassens einer Einheit (117) zur Berechnung des korrigierten Vorstroms, den Vorstrom unter Verwendung des Temperaturkorrekturwertes zu korrigieren, wobei der Vorstrom zum Zeitpunkt der Verschlechterungsdiagnose erfasst wird; und
einen sechsten Schritt des Veranlassens einer Vorstrom-Änderungsbetrags-Berechnungseinheit (118), eine Differenz zwischen einem anfänglichen Vorstrom und einem korrigierten Vorstrom mit einem vorgeschriebenen Schwellenwert zu vergleichen, wobei der anfängliche Vorstrom ein Anfangswert eines Vorstroms ist, der von der Vorstromerfassungseinheit (112) erfasst wird, wenn der Betrieb vor der spezifischen Zeitspanne gestartet wird, wobei der korrigierte Vorstrom durch Korrigieren des Vorstroms erhalten wird, und Veranlassen der Vorstrom-Änderungsbetrags-Berechnungseinheit (118) zu bestimmen, dass sich die in dem optischen Transceiver (101) enthaltene Laserdiode (105) verschlechtert hat, und eine Anweisung zum Austausch des optischen Transceivers (101) auszugeben, wenn die Differenz gleich oder größer als der vorgeschriebene Schwellenwert ist.

## Revendications

1. Dispositif de diagnostic de détérioration (102) pour diagnostiquer la détérioration d'un émetteur-récepteur optique (101), le dispositif de diagnostic de détérioration (102) comprenant :
une unité d'acquisition de température (111) configurée pour acquérir une température de l'émetteur-récepteur optique (101) comportant une diode laser (105), la diode laser (105) étant configurée pour émettre un signal de transmission optique ;
une unité d'acquisition de courant de polarisation (112) configurée pour acquérir un courant de polarisation circulant à travers la diode laser (105) ;
une unité de commande de courant d'entraînement (108) configurée pour commander le courant de polarisation circulant à travers la diode laser afin de rendre constante l'intensité de la lumière émise par le signal de transmission optique ;
une unité de calcul de fonction de correction (114) configurée pour calculer une fonction de correction représentant une pluralité de températures et une pluralité de courants de polarisation, la pluralité de températures étant obtenue à la suite du fait que l'unité d'acquisition de température (111) acquiert la température de l'émetteur-récepteur optique (101) plusieurs fois pendant une période spécifique après que l'opération a démarré, la pluralité de courants de polarisation étant obtenue à la suite du fait que l'unité d'acquisition de courant de polarisation (112) acquiert le courant de polarisation de la diode laser (105) plusieurs fois pendant la période spécifique après que l'opération a démarré ;
une unité de calcul de valeur de correction de température (116) configurée pour calculer une valeur de correction de température pour un courant de polarisation acquis par l'unité d'acquisition de courant de polarisation (112) au moment du diagnostic de détérioration après la période de temps spécifique, en utilisant une température de l'émetteur-récepteur optique (101) acquise par l'unité d'acquisition de température (111) au moment du diagnostic de détérioration après la période de temps spécifique, une température initiale, et la fonction de correction, la valeur de correction de température représentant une quantité de changement causée par une différence de température entre la température initiale et la température acquise au moment du diagnostic de détérioration, la température initiale étant une température de l'émetteur-récepteur optique (101) acquise par l'unité d'acquisition de température (111) lorsque l'opération est démarrée avant la période de temps spécifique ;
une unité de calcul de courant de polarisation corrigé (117) configurée pour corriger le courant de polarisation à l'aide de la valeur de correction de température, le courant de polarisation étant acquis au moment du diagnostic de détérioration ; et
une unité de calcul de quantité de changement de courant de polarisation (118) configurée pour comparer une différence entre un courant de polarisation initial et un courant de polarisation corrigé avec une valeur seuil prescrite, le courant de polarisation initial étant une valeur initiale d'un courant de polarisation acquis par l'unité d'acquisition de courant de polarisation (112) lorsque l'opération est démarrée avant la période de temps spécifique, le courant de polarisation corrigé étant obtenu par correction du courant de polarisation, l'unité de calcul de quantité de changement de courant de polarisation (118) déterminant que la diode laser (105) incluse dans l'émetteur-récepteur optique (101) s'est détériorée et émettant une instruction de remplacement de l'émetteur-récepteur optique (101) lorsque la différence est égale ou supérieure à la valeur de seuil prescrite.

2. Procédé de diagnostic de la détérioration d'un émetteur-récepteur optique (101) à l'aide d'un dispositif de diagnostic de détérioration (102) pour diagnostiquer la détérioration d'un émetteur-récepteur optique (101), le procédé comprenant :
une première étape consistant à amener une unité d'acquisition de température (111) à acquérir une température de l'émetteur-récepteur optique (101) comprenant une diode laser (105), la diode laser (105) émettant un signal de transmission optique ;
une deuxième étape consistant à amener une unité d'acquisition de courant de polarisation (112) à acquérir un courant de polarisation circulant à travers la diode laser (105), dans lequel une unité de commande de courant d'entraînement (108) commande le courant de polarisation circulant à travers la diode laser afin de rendre constante l'intensité de sortie de lumière du signal de transmission optique ;
une troisième étape consistant à amener une unité de calcul de fonction de correction (114) à calculer une fonction de correction représentant les relations entre une pluralité de températures et une pluralité de courants de polarisation, la pluralité de températures étant obtenue à la suite du fait que l'unité d'acquisition de température (111) acquiert la température de l'émetteur-récepteur optique (101) plusieurs fois au cours d'une période spécifique après que l'opération a démarré, la pluralité de courants de polarisation étant obtenue à la suite du fait que l'unité d'acquisition de courant de polarisation (112) acquiert le courant de polarisation de la diode laser (105) plusieurs fois pendant la période spécifique après que l'opération a démarré ;
une quatrième étape consistant à amener une unité de calcul de valeur de correction de température (116) à calculer une valeur de correction de température pour un courant de polarisation acquis par l'unité d'acquisition de courant de polarisation (112) au moment du diagnostic de détérioration après la période de temps spécifique, en utilisant une température de l'émetteur-récepteur optique (101) acquise par l'unité d'acquisition de température (111) au moment du diagnostic de détérioration après la période de temps spécifique, une température initiale, et la fonction de correction, la valeur de correction de température représentant une quantité de changement causée par une différence de température entre la température initiale et la température acquise au moment du diagnostic de détérioration, la température initiale étant une température de l'émetteur-récepteur optique (101) acquise par l'unité d'acquisition de température (111) lorsque l'opération est démarrée avant la période de temps spécifique ;
une cinquième étape consistant à amener une unité de calcul de courant de polarisation corrigé (117) à corriger le courant de polarisation à l'aide de la valeur de correction de température, le courant de polarisation étant acquis au moment du diagnostic de détérioration ; et
une sixième étape consistant à amener une unité de calcul de quantité de changement de courant de polarisation (118) à comparer une différence entre un courant de polarisation initial et un courant de polarisation corrigé avec une valeur seuil prescrite, le courant de polarisation initial étant une valeur initiale d'un courant de polarisation acquis par l'unité d'acquisition de courant de polarisation (112) lorsque l'opération est démarrée avant la période de temps spécifique, le courant de polarisation corrigé étant obtenu par correction du courant de polarisation et à amener l'unité de calcul de quantité de changement de courant de polarisation (118) à déterminer que la diode laser (105) incluse dans l'émetteur-récepteur optique (101) s'est détériorée et à émettre une instruction pour remplacer l'émetteur-récepteur optique (101) lorsque la différence est égale ou supérieure à la valeur de seuil prescrite.
